# EUROPÄISCHE PATENTSCHRIFT

(11) **EP 3 182 565 B1**
(45) Veröffentlichungstag und Bekanntmachung des Hinweises auf die Patenterteilung: **01.01.2020**
(21) Anmeldenummer: 16002423.8
(22) Anmeldetag: 15.11.2016
(51) Int. Cl.: H02K 11/33, H05K 7/20, H02K 5/18, H02K 7/14, H02K 5/22

(54) **ELEKTRONIKGEHÄUSE MIT KÜHLRIPPEN**
ELECTRONICS HOUSING WITH COOLING FINS
BOÎTIER ÉLECTRONIQUE COMPRENANT DES AILETTES

(30) Priorität: 15.12.2015 DE 102015016260
(43) Veröffentlichungstag der Anmeldung: 21.06.2017
(73) Patentinhaber: WILO SE, 44263 Dortmund (DE)
(72) Erfinder: Karns, Stephan, 59348 Lüdinghausen (DE); Schmelter, Tina, 58093 Hagen (DE)
(74) Vertreter: Cohausz Hannig Borkowski Wißgott

(56) Entgegenhaltungen:
- EP-A1- 2 607 708
- EP-A1- 2 626 566
- DE-A1- 10 065 796
- DE-T2- 69 510 443
- DE-U1- 7 923 977
- DE-U1- 29 880 160
- JP-A- 2005 303 063

## Beschreibung

Die Erfindung betrifft eine Zentrifugalpumpe mit einem sie antreibenden Elektromotor und einem auf ein Motorgehäuse des Elektromotors montierten Elektronikgehäuse mit einem wannenförmigen Unterteil zur Aufnahme zumindest eines wärmeerzeugenden Bauelements, insbesondere leistungselektronischer Bauelemente eines Frequenzumrichters und einem das Unterteil abdeckenden Oberteil, wobei das Unterteil einen Boden sowie sich davon in Richtung des Oberteils erstreckende Seitenwände aufweist und zumindest der Boden aus einem wärmeleitfähigen Material besteht.

Ein Elektronikgehäuse dieser Bauart ist beispielsweise aus der deutschen Patentanmeldung DE 10065796 bekannt. Es wird hier auf die an einem Axialende des Motorgehäuses vorhandene Stirnseite aufgesetzt, so dass in dem Oberteil vorhandene Anzeige- und Bedienelemente zum Benutzer gerichtet sind. Das Elektronikgehäuse nimmt die Motor- und/oder Pumpenelektronik auf, die zur Ansteuerung respektive Regelung des Motors bzw. der Pumpe vorgesehen ist. Zur Drehzahlregelung werden regelmäßig Frequenzumrichter eingesetzt, deren leistungselektronische Bauelemente im Betrieb Wärme erzeugen, die abgeleitet und an die Umgebung abgegeben werden muss. Dies ist vor allem bei Pumpenaggregaten mittlerer und hoher Leistung der Fall, wobei mit zunehmender Leistungsabgabe des Elektromotors auch zunehmend Abwärme entsteht.

Die europäischen Patentanmeldungen EP 2607708 A1 und EP 2626566 A1 offenbaren jeweils einen Elektromotor, dessen Gehäuse außen mit Kühlrippen versehen ist, welche sich umfänglich um 180° erstrecken und fluchtend in Kühlrippen eines seitlich neben dem Elektromotor liegenden Radialgehäuses, das Teil eines Elektronikgehäuses der Pumpe ist. Das Elektronikgehäuse besteht insgesamt aus diesem Radialgehäuse und einem Axialgehäuse, das an die axiale Stirnseite des Elektromotors montiert ist und diese zur Seite hin derart überragt, dass das Axial- und Radialgehäuse an dieser Seite ineinander übergehen.

Der Elektromotor der erfindungsgemäßen Zentrifugalpumpe ist bestimmungsgemäß zum Antrieb der Zentrifugalpumpe vorgesehen, die beispielsweise in der Anwendung als Heizungspumpe oder Kühlmittelpumpe bestimmungsgemäß betrieben sein kann. Bei derartigen Umwälzpumpen ist es üblich, den Stutzen für den saugseitigen Anschluss des Pumpengehäuses koaxial mit dem Stutzen für den druckseitigen Anschluss auszubilden, so dass Saugstutzen und Druckstutzen dieselbe Achse besitzen. Derartige Pumpen sind auch als "Inline"-Pumpen bekannt.

Die Motorachse respektive Pumpenachse kann bei diesen Pumpen sowohl horizontal als auch vertikal verlaufen. Betrachtet man beispielsweise eine horizontale Pumpenachse, so kann die an den Saug- und Druckstutzen anzuschließende Verrohrung, stets rechtwinklig zur Pumpenachse liegend, sowohl horizontal als auch vertikal verlaufen. Um für beide Einbaulagen zu gewährleisten, dass an der Pumpe vorhandene Anzeige- und/oder Bedienelemente stets betrachtungs- und lesegerecht ausgerichtet sind, und nicht etwa zu einer Seite gekippt sind oder gar auf dem Kopf stehen, sind Elektronikgehäuse in der Regel in vier verschiedenen Ausrichtungspositionen auf das Motorgehäuse montierbar, d.h. sie können um 90° oder 180° im Uhrzeigersinn oder gegen den Uhrzeigersinn bezogen auf die Stirnseite des Motorgehäuses gedreht aufgesetzt werden. Da in jeder dieser Montagepositionen die Kühlung sichergestellt werden muss, können keine konventionellen Kühlrippen, die parallel zu einer Erstreckungsrichtung des Elektronikgehäuses verlaufen, verwendet werden. Denn hier wäre nicht gewährleistet, dass in jeder Montageposition Konvektion möglich ist.

Ein aus zwei Teilen bestehendes Elektronikgehäuse für einen Elektromotor einer Kreiselpumpe, bei dem ein Gehäuseteil axialseitig des Elektromotors, das andere Gehäuseteil radialseitig an den Elektromotor angesetzt wird, ist aus der europäischen Patentanmeldung EP 2607707 A1 bekannt. Hier weist das radial anzusetzende Gehäuseteil zum Elektromotor gerichtete Rippen auf, die diesen in Umfangsrichtung umgreifen. Dementsprechend sind die Kühlrippen außenseitig länger ausgebildet als im mittleren Bereich des Radialgehäuses, wo der Abstand zwischen dem Boden und dem Motorgehäuse entsprechend am geringsten ist. Das Gehäuse ist aus einer Leichtmetalllegierung als Druckgussbauteil ausgebildet. Innenseitig des Bodens sind Anschlussflächen ausgebildet, die wärmeleitend mit Leistungsbauteilen in Kontakt stehen, so dass die Wärme über den Boden an die Kühlrippen abgegeben wird. Aufgrund der Erstreckung der Kühlrippen in Umfangsrichtung kann das Radialgehäuse für eine Konvektion der Luftströmung nicht an jeder beliebigen Stelle des Elektromotors angeordnet werden. Bei waagerechter Motorwelle sind deshalb nur die Positionen rechts- und linksseits der Motorwelle möglich. Bei einer vertikal angeordneten Motorwelle ist die Verwendung des Radialgehäuses gänzlich ausgeschlossen, weil die sich dann waagerecht erstreckenden Kühlrippen eine Konvektion der Wärmeströmung gänzlich verhindern.

Die Übersetzung der europäischen Patentschrift EP 0741958 B1 in Gestalt der DE 695 10 443 T2 beschreibt eine Telekommunikationseinheit für Kabelfernsehen oder Telefonübertragung und -empfang, die auf der Rückseite ein Kühlteil mit schräg zur Längsabmessung verlaufenden Kühlrippen offenbart. Ähnliches zeigt das deutsche Gebrauchsmuster DE 79 23 977 U1 für ein Gehäuse der Nachrichtentechnik.

Ein Kühlkörper mit schrägen Kühlrippen ist aus der deutschen Gebrauchsmusterschrift DE 298 80 160 U1 und der japanischen Patentanmeldung JP 2005/303063 A bekannt.

Es ist Aufgabe der vorliegenden Erfindung eine Zentrifugalpumpe mit einem Kühlrippen aufweisenden Elektronikgehäuse bereitzustellen, das eine erhöhte Flexibilität bei der Anordnung am Motorgehäuse ermöglicht.

Diese Aufgabe wird durch ein Elektronikgehäuse mit den Merkmalen des Anspruchs 1 gelöst. Vorteilhafte Weiterbildungen sind in den Unteransprüchen angegeben und werden nachfolgend erläutert.

Erfindungsgemäß wird eine Zentrifugalpumpe mit einem Elektronikgehäuse vorgeschlagen, bei dem auf der dem Oberteil abgewandten Rückseite des Unterteils Kühlrippen einstückig mit dem Boden ausgebildet sind, die zumindest abschnittsweise in einem Winkel zwischen 30° und 60° zu einer Erstreckungsrichtung der Rückseite verlaufen. Das Unterteil bildet somit quasi einen Kühlkörper, dessen Boden die Basisplatte darstellt, von der sich die Kühlrippen weg erstrecken. Durch die Schrägstellung der Kühlrippen kann das Elektronikgehäuse in verschiedenen Montagepositionen bei stets gewährleisteterer Kühlwirkung montiert werden.

Der Boden ist vorzugsweise aus einem Material mit einer Wärmeleitfähigkeit von mindestens 150W/(m·K), idealerweise mindestens 200 W/(m·K). Er kann aus Metall, beispielsweise Aluminium bestehen oder aus einem wärmeleitfähigen Kunststoff hergestellt sein. Vorzugsweise sind auch die Seitenwände aus einem wärmeleitfähigen Material, beispielsweise mit einer Wärmeleitfähigkeit von mindestens 150W/(m·K), idealerweise von mindestens 200 W/(m·K). Auch die Seitenwände können aus Dabei können die Seitenwände aus Metall, beispielsweise Aluminium bestehen oder aus einem wärmeleitfähigen Kunststoff hergestellt sein. Dabei ist es ferner bevorzugt, den Boden und die Seitenwände einstückig auszuführen, beispielsweise in einem Stück aus Metall oder Kunststoff zu gießen oder Seitenwände aus Kunststoff an einen Boden aus Metall anzuspritzen.

Ist das Elektronikgehäuse beispielsweise auf die axiale Stirnseite eines eine Zentrifugalpumpe antreibenden Elektromotors mit horizontaler Motorachse zu montieren, so ist aufgrund der Schrägstellung der Kühlrippen in jeder der 90°-Montagepositionen an der Stirnseite gewährleistet, dass eine Konvektion der Luftströmung durch die Kanäle zwischen zwei zueinander benachbarten Kühlrippen stattfinden kann. Gleiches gilt bei einem Elektromotor, dessen Motorachse senkrecht liegt und bei dem das Elektronikgehäuse radial an das Motorgehäuse angesetzt wird und für die Montage in zwei oder mehr verschiedenen Ausrichtungen relativ zum Motorgehäuse vorgesehen ist. In beiden genannten Fällen, d.h. sowohl bei einer axialseitigen Montage am Elektromotor mit horizontaler Achse als auch radialseitiger Montage bei einem Elektromotor mit vertikaler Achse liegt die Rückseite des Bodens des Unterteils des Elektronikgehäuses in einer Vertikalebene. Sie kann jedoch auch in einer Horizontalebene liegen, beispielsweise, wenn bei einer horizontalen Motorachse eine radiale Montage an der Oberseite des Motorgehäuses, d.h. am höchsten Punkt des Außenmantels des Motorgehäuses erfolgt.

Bei einem Schrägstellungswinkel zwischen 30° und 60° ist gewährleistet, dass in jeder Ausrichtungsposition des Elektronikgehäuses Konvektion oder eine künstlich erzeugte Luftströmung effektiv durch die Kühlkanäle zwischen zwei benachbarten Kühlrippen erfolgen kann. Bei vertikaler Anordnung des Elektronikgehäuses kann eine Konvektion in jeder Montageposition stattfinden. Ferner kann eine Anströmung der Kühlrippen in jeder beliebigen Montageposition unter Ausbildung einer Strömung in den Kühlkanälen erfolgen. Vorzugsweise ist dies bei allen Kühlkanälen der Fall, sofern die Kühlkanäle zu jeder Seite hin offen sind und keine Rippe einen potentiellen Strömungsweg versperrt. Gleichwohl können einzelne Kühlkanäle aus Designgründen durch Querrippen verbunden sein, welche dann zwar ein Strömungshindernis bilden, bilden, jedoch die Gesamtkühlleistung der Kühlrippen nicht wesentlich beeinträchtigen.

Gemäß einer bevorzugten Ausführungsvariante beträgt der Winkel, in dem die Kühlrippen zu der einen Erstreckungsrichtung der Rückseite verlaufen, 45°. Dies bewirkt, dass die Durchströmung der Kühlkanäle in allen Montagepositionen gleich ist. Im Gegensatz hierzu bedeutet ein Winkel von 30° in einer Erstreckungsrichtung des Elektronikgehäuses, dass in eine andere Erstreckungsrichtung ein Winkel von 60° vorliegt. Dies führt zu geringfügig unterschiedlichen thermischen Eigenschaften, weil die Strömungsgeschwindigkeiten in den Kühlkanälen unterschiedlich sind. So ist im Falle der Konvektion die Strömungsgeschwindigkeit am höchsten, wenn die Rippen respektive die Kühlkanäle senkrecht verlaufen, d.h. 90° zur Erstreckungsrichtung bzw. parallel zur anderen Erstreckungsrichtung der Rückseite des Elektronikgehäuses. Je kleiner nun der Winkel wird, desto geringer wird im Fall der Konvektion die Strömungsgeschwindigkeit.

Gleiches gilt bei der Anströmung der Kühlrippen durch eine aktive Luftkühlung. Verlaufen die Kühlrippen parallel zur Luftströmung besteht kein Strömungswiderstand. Ein solcher ist jedoch zunehmend vorhanden, wenn die Kühlrippen im Winkel zur Anströmungsrichtung liegen und die Strömung umlenken. Der Strömungswiderstand ist dann bei 60° geringer als bei 30° weil Letzteres eine Umlenkung um 60° bedeutet. Wird dagegen eine Schrägstellung der Rippen in einem Winkel von 45° gewählt, kommt es auf die Orientierung der Kühlrippen zur Luftströmung respektive in Konvektionsrichtung nicht an.

Bei der Erstreckungsrichtung kann es sich beispielsweise um die Quererstreckung oder die Längserstreckung der Rückseite des Unterteils des Elektronikgehäuses handeln. Obgleich das Elektronikgehäuse vorzugsweise kastenförmig ist, d.h. im Wesentlichen einen rechteckigen Querschnitt aufweist, ist das erfindungsgemäße Elektronikgehäuse nicht auf eine solche Geometrie festgelegt. So kann das Elektronikgehäuse respektive das Unterteil auch eine andere geometrische Form besitzen, beispielsweise eine runde oder ovale Querschnittsform. In diesem Fall entspricht die Erstreckungsrichtung einer der Symmetrieachsen oder beispielsweise dem Durchmesser.

Gemäß einer bevorzugten Ausführungsvariante weist die Rückseite des Bodens einen kühlrippenfreien Anlagenbereich zum Ansetzen des Elektronikgehäuses an das Motorgehäuse auf. Dies bedeutet, dass im montierten Zustand des Elektronikgehäuses am Motorgehäuse keine Rippen zwischen dem Boden und dem Motorgehäuse vorhanden sind. Somit findet auch keine Konvektion oder künstliche Luftströmung zwischen Motorgehäuse und Anlagenbereich statt. Somit kann auch auf Abstandshalter verzichtet werden, die die Höhe der Rippen für die Montage des Elektronikgehäuses am Motorgehäuse überbrücken müssten.

Der Elektromotor zum Antreiben der Zentrifugalpumpe umfasst erfindungsgemäß ein Motorgehäuse und eine Motorelektronik zu seiner Steuerung und/oder Regelung, wobei am Motorgehäuse ein Elektronikgehäuse der vorbeschriebenen Art montiert ist.

Die Montage erfolgt vorzugsweise an einer axialen Stirnseite des Motorgehäuses, so dass Anzeige- und/oder Bedienmittel im Oberteil des Elektronikgehäuses zum Nutzer gerichtet sind beziehungsweise gerichtet werden können. Geeigneterweise ist das Elektronikgehäuse mit seinem kühlrippenfreien Anlagenbereich an die axiale Stirnseite des Motorgehäuses montiert, wobei die Kühlrippen in radialer Richtung seitlich neben dem Motorgehäuse liegen, sich insbesondere achsparallel zur Motorachse erstrecken. Die Baueinheit aus Elektromotor und Elektronikgehäuse ist somit besonders kompakt und ist besonders kleinbauend hinsichtlich ihres axialen Bauraums.

Bei der Montage des Elektronikgehäuses an einer axialen Stirnseite des Motorgehäuses kann der Anlagenbereich idealerweise dem Querschnitt des Motorgehäuses entsprechen. Von der Rückseite des Bodens muss also nicht unbedingt ein größerer Teilbereich als der Motorquerschnitt rippenfrei sein. Gleichwohl ist es zum einen von Vorteil, wenn die Kühlrippen in einem Abstand vor dem Anlagenbereich enden. Hierdurch wird erreicht, dass die Rippen im montierten Zustand des Elektronikgehäuses nicht am Außenumfang des Motorgehäuses anliegen sondern beabstandet zu diesem sind, und somit auch eine Luftströmung/ Konvektion in Umfangsrichtung um das Motorgehäuse erfolgen kann.

Zusätzlich oder alternativ zum rippenfreien Anlagenbereich kann ein anderer Teilbereich der Rückseite des Bodens, insbesondere ein außerhalb des Anlagenbereichs liegender Teilbereich der Rückseite frei von Kühlrippen sein. Dies ist insbesondre dann von Vorteil, wenn der übrige, mit Rippen versehene Bereich der Rückseite schon ausreicht um die entstehende Abwärme der Leistungselektronik und ggf. des Elektromotors abzuführen. Durch den rippenfreien Teilbereich wird Material eingespart und das Gewicht des Elektronikgehäuses reduziert.

Das wannenförmige Unterteil nimmt erfindungsgemäß die Motorelektronik respektive Pumpenelektronik auf, die zur Steuerung und/oder Regelung des Elektromotors respektive der Pumpe vorgesehen und eingerichtet ist. Um einen besonders guten Wärmeübergang der wärmeerzeugenden Bauteile zum Boden respektive den Kühlrippen zu schaffen, kann eine Relieffierung des Bodens innenseitig des Unterteils vorhanden sein. So kann insbesondere zumindest eine Vertiefung zur bodenkontaktierenden Aufnahme des oder zumindest eines der Wärme abgebenden, elektronischen Bauelements/ Bauelemente vorhanden sein. Rückseitig dieser Vertiefung sind entsprechend Kühlrippen vorhanden, um die Wärme an die Luft abzugeben. Dabei kann die Aufnahme geeigneterweise formschlüssig sein, so dass nicht nur eine einzige Kontaktfläche zwischen dem Bauelement und dem Boden existiert, sondern zwei oder mehr. So können vorzugsweise sogar fünf Kontaktflächen zwischen dem Bauelement und dem Boden bestehen, nämlich bei einem quaderförmigen Bauelement eine erste Kontaktfläche an der den Rippen zugekehrten Seite des Bauelements und jeweils zwei weitere Kontaktflächen an den beiden Längs- und Querseiten des Bauelements zum Boden.

Üblicherweise kann zwischen dem Bauteil und dem Boden ein wärmeleitendes Mittel, beispielsweise eine Wärmeleitpaste vorhanden sein, um eine optimale Wärmeleitfähigkeit und Wärmeübertragung vom Bauelement zum Boden zu erreichen.

Der Boden kann außenseitig im gesamten Bereich der Vertiefung einen Vorsprung aufweisen, so dass die Dicke des Bodens im Bereich der Vertiefung nicht dünner sein muss als an anderen Stellen. Umgekehrt betrachtet muss durch den Vorsprung der Boden in seiner Gesamtheit nicht unnötig dick ausgeführt werden, um in einem Teilbereich die Vertiefung ausbilden zu können.

Der Vorsprung liegt vorzugsweise seitlich neben dem Anlagenbereich, so dass er im montierten Zustand des Elektronikgehäuses am Motorgehäuse seitlich neben dem Motorgehäuse angeordnet ist. Somit wird der Bauraum für die aus dem Elektromotor im Elektronikgehäuse bestehende Einheit durch den Vorsprung nicht vergrößert.

Gemäß einer bevorzugten Ausführungsvariante des Elektronikgehäuses nimmt die Dicke der Kühlrippen zu ihrem freien Ende hin jeweils ab. Dies bedeutet, dass sie im Querschnitt betrachtet annähernd keilförmig sind. Die Dicke der Kühlrippen ist an ihrer Basis, d.h. an ihrem in den Boden übergehenden Ende am größten und nimmt in Richtung des gegenüberliegenden freien Endes ab. Hierdurch wird die Wärmeangabe der Rippen im Bereich des freien Endes verbessert. Ferner ergibt sich hierdurch eine Formschräge, die eine bessere Entformbarkeit beim Gießen oder Spritzgießen des Bodenteils bewirken. Eine weitere vorteilhafte Wirkung der keilförmigen Kühlrippen ist, dass auch die Kühlkanäle zwischen den Kühlrippen mit zunehmendem Abstand vom Boden breiter werden. Die Kühlkanäle sind somit im Querschnitt annähernd trapezförmig, so dass die Konvektion verbessert wird.

Der Abstand zweier benachbarter Kühlrippen beträgt an ihrer bodennahen Basis geeigneter Weise den 1,0-fachen bis 5,0-fachen der Dicke der Kühlrippen. Hierdurch werden die Strömungseigenschaften einer Konvektionsströmung oder künstlichen Luftströmung durch die Kühlkanäle verbessert.
Das Unterteil des Elektronikgehäuses kann einen im Wesentlichen rechteckförmigen Querschnitt aufweisen und das Motorgehäuse an einer Seite weiter überragen als an der gegenüberliegenden anderen Seite. Zumindest an dieser das Motorgehäuse weiter überragenden Seite weist der Boden dann Kühlrippen auf. Das Elektronikgehäuse ist somit bezogen auf seine Längserstreckung nicht mittig auf das Motorgehäuse bzw. außermittig montiert. Hierdurch wird eine maximale durchgehende Länge der Kühlrippen erreicht, was wiederum die Konvektion verbessert.

Des Weiteren ist es von Vorteil, wenn sich die Kühlrippen über zumindest ein Viertel der axialen Länge des Motorgehäuses erstrecken. Die Kühlrippen besitzen somit eine Höhe, die mindestens einem Viertel der axialen Länge des Motorgehäuses entspricht, vorzugsweise zwischen einem Viertel und zwei Drittel der axialen Motorgehäuselänge liegt. Die Höhe ist die wesentliche Größe bei den Kühlrippen, die die Größe der Oberfläche der Kühlrippen bestimmt und damit das Maß der Wärmeabgabe festlegt.

Die Kühlrippen können in Richtung ihres zu einer Seitenwand hin auslaufenden Endes zumindest einen Knick aufweisen, um rechtwinklig zur jeweiligen Seitenwand auszulaufen. Dies erhöht die mechanische Stabilität.

In zumindest einer Ecke der Rückseite des Bodens, die in einer Flucht mit einem der Kühlkanäle liegt, kann eine Pseudorippe angeordnet sein. Durch diese zusätzliche Rippe wird der Mündungsbereich dieses Kühlkanals reduziert und die Kühlleistung erhöht. Die Pseudorippe kann in eine benachbarte Kühlrippe übergehen, um die mechanische Stabilität zu erhöhen, da die Pseudorippe vergleichsweise kurz ist und auf der Ecke liegt, wo sie durch den Umgang mit dem Unterteil einer erhöhten Stoß- und Bruchgefahr ausgesetzt ist. Sie kann zwei durch einen Knick voneinander getrennte Abschnitte aufweisen, um ein einheitliches Bild mit den anderen Kühlrippen zu erreichen. Vorzugsweise verlaufen der erste Abschnitt parallel zur Haupterstreckungsrichtung der anderen benachbarten Kühlrippe und der zweite Abschnitt parallel zu dem zu einer Seitenwand auslaufenden Ende dieser anderen benachbarten Kühlrippe.

Es ist ferner von Vorteil, wenn in zumindest einer anderen Ecke der Rückseite des Bodens eine Stummelrippe angeordnet ist, die sich quer zu den übrigen Kühlrippen erstreckt. hierdurch wird der Freiraum auf der Ecke ebenfalls zur Erhöhung der Kühlleistung verwendet. Die Stummelrippe kann in die benachbarte Kühlrippe übergehen. Auch dies dient der mechanischen Stabilisierung, da die Stummelrippe vergleichsweise kurz ist und auf der Ecke liegt, wo sie durch den Umgang mit dem Unterteil einer erhöhten Stoß- und Bruchgefahr ausgesetzt ist.

Weitere Merkmale und Vorteile der Erfindung werden nachfolgend anhand eines Ausführungsbeispiels und der beigefügten Figuren erläutert. Es zeigen:
- Figur 1:: perspektivische Ansicht auf ein erfindungsgemäßes Elektronikgehäuse, stirnseitig an ein Motorgehäuse montiert;
- Figur 2:: perspektivische Ansicht des Unterteils des Elektronikgehäuses ohne Motorgehäuse;
- Figur 3:: rückseitige Ansicht des Unterteils des Elektronikgehäuses;
- Figur 4:: Ansicht des Unterteils des Elektronikgehäuses von oben;
- Figur 5:: Rückansicht der Baueinheit aus Elektronikgehäuse und Elektromotor gemäß Figur 1 in einer ersten Montageposition des Elektromotors;
- Figur 6:: Rückansicht der Baueinheit aus Elektronikgehäuse und Elektromotor in einer zweiten Montageposition des Elektromotors;
- Figur 7:: rückseitige Ansicht auf ein weiteres erfindungsgemäßes Elektronikgehäuse;
- Figur 8:: perspektivische Ansicht auf das weitere Elektronikgehäuse;
- Figur 9:: perspektivische Ansicht auf das weitere Elektronikgehäuse mit Führungskappe;

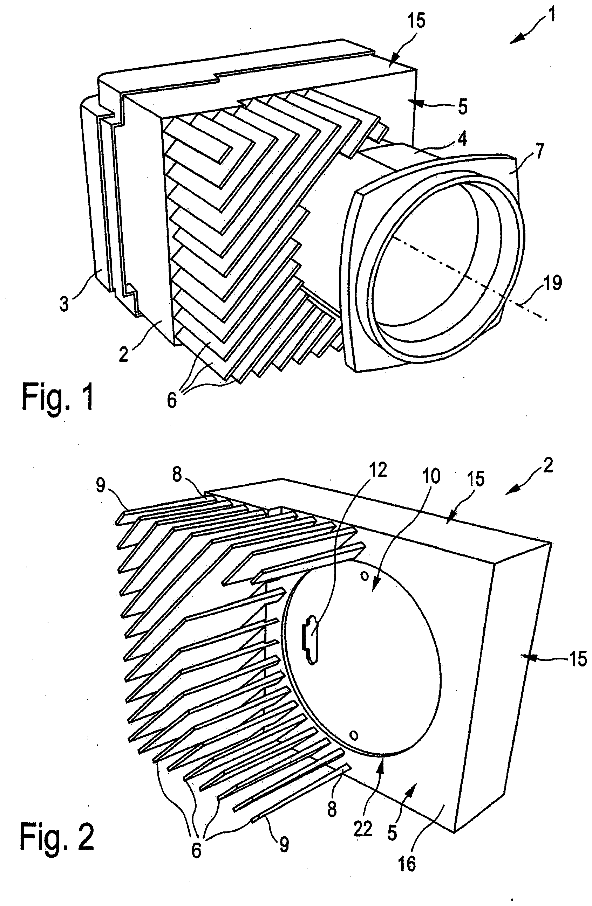

Figur 1 zeigt eine perspektivische Darstellung eines erfindungsgemäßen Elektronikgehäuses 1, das an die an einem axialen Ende eines Motorgehäuses 4 vorhandene Stirnseite montiert ist. Das Motorgehäuse 4 bildet das Statorgehäuse eines nicht in weiteren Einzelheiten dargestellten Elektromotors, welcher wiederum eine ebenfalls nicht dargestellte Zentrifugalpumpe antreibt. Elektromotor und Zentrifugalpumpe bilden baulich oder zumindest funktional eine Einheit im Sinne eines Pumpenaggregats. An dem dem Elektronikgehäuse 1 gegenüberliegenden Axialende des Motorgehäuses 4 ist ein Pumpenflansch 7 vorhanden, mit dem das Motorgehäuse an ein Pumpengehäuse der Zentrifugalpumpe bestimmungsgemäß verbunden wird. Der Elektromotor kann als Nassläufer ausgebildet sein, d.h. dass sein Rotor in einem mit Flüssigkeit, insbesondere mit dem Fördermedium gefüllten Rotorraum dreht. Mit der Bezugsziffer 19 ist in Figur 1 die Motorachse respektive die Pumpenachse gekennzeichnet.

Das Elektronikgehäuse 1 besteht im Wesentlichen aus einem wannenförmigen Unterteil 2 und einem dieses abdeckende Oberteil 3. Das Unterteil 2 ist aus einer Leichtmetalllegierung, insbesondere aus Aluminiumdruckguss hergestellt, wohingegen das Oberteil 3 aus einem Kunststoff besteht. In dem Oberteil können Anzeige- und/oder Bedienelemente vorhanden sein, insbesondere ein Display, Leuchtmittel wie beispielsweise LEDs, ein Drehknopf und/oder Tasten.

Wie in den Figuren 2 bis 4 näher zu erkennen ist, besteht das Unterteil aus einem Boden 16 sowie sich davon in Richtung des Oberteils erstreckende Seitenwände 15. Allerdings müssen der Boden 16 und die Seitenwände 15 nicht unbedingt einstückig, insbesondere einstückig aus Metall ausgeführt sein. Das Unterteil ist im Wesentlichen kastenförmig ausgebildet und weist einen rechteckigen Querschnitt auf. Auf der dem Oberteil 3 abgewandten Rückseite 5 des Unterteils sind Kühlrippen 6 vorhanden, die einstückig mit dem Boden ausgebildet sind. Somit bildet das Unterteil des Elektronikgehäuses quasi einen integrierten Kühlkörper.

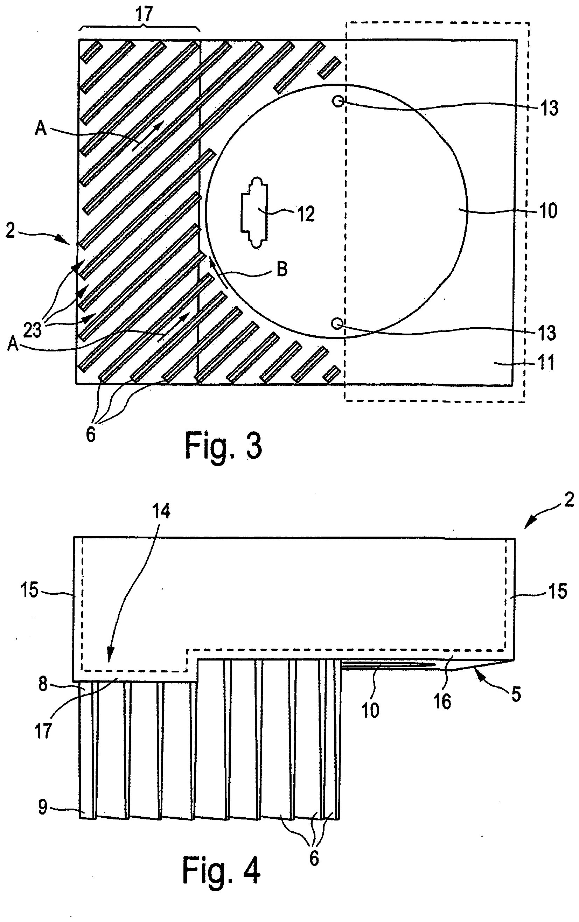

Im Querschnitt sind die Kühlrippen keilförmig. Sie besitzen an ihrer mit dem Boden 16 verbundenen Basis 8 eine Dicke die größer ist als an ihrem freien Ende 9. Zwischen zwei benachbarten Kühlrippen 6 ist jeweils ein Kühlkanal 23 gebildet, in den Konvektionsluft in Richtung des in Figur 3 dargestellten Pfeils A strömen kann.

Nicht die gesamte Rückseite 5 des Bodens 16 ist mit Kühlrippen versehen. Vielmehr gibt es einen rippenfreien Teilbereich 11, der auf einer Seite des Elektronikgehäuses liegt. Dies ist dem Umstand geschuldet, dass auf der anderen Seite dieses rippenfreien Bereichs 11 im Inneren des Unterteils 2 keine wärmeerzeugenden Bauelemente vorhanden sind. Aus diesem Grunde können in diesem Bereich die Rippen weggelassen werden, so dass Material und Gewicht beim Unterteil eingespart werden kann.

Darüber hinaus ist auch derjenige Bereich der Rückseite 5 des Unterteils 2 frei von Rippen, der einen Anlagebereich 10 zum Ansetzen des Elektronikgehäuses 1 an das Motorgehäuse 4 bildet. Dieser Anlagenbereich 10 ist entsprechend der Außengeometrie des Motorgehäuses 4 kreisrund ausgebildet. Somit kann der Boden 16 an die Stirnseite des Motorgehäuses 4 angesetzt werden. Es befinden sich somit keine Rippen zwischen dem Unterteil 2 und dem Motorgehäuse 4, so dass die axiale Baulänge der aus dem Elektromotor und dem Elektronikgehäuse gebildeten Einheit gering ist.

Der Anlagenbereich 10 ist gegenüber der übrigen Rückseite 5 vertieft, wie man anhand des Rücksprungs 22 in Figur 2 erkennen kann. Somit umgreift das Unterteil 2 das Motorgehäuse 4 geringfügig.

Die Montage des Elektronikgehäuses 1 am Motorgehäuse 4 erfolgt mittels Schrauben durch entsprechende Bohrungen 13, die in Figur 3 gut zu sehen sind. Zur elektrischen Kontaktierung der Statorwicklung weist das Unterteil 2 ferner eine Öffnung 12 zur Durchführung von Steckkontakten auf, die entweder motorseitig an den Statorwicklungen oder elektronikseitig an einer elektrischen Baugruppe, insbesondere einer Platine im inneren des Unterteils 2 vorhanden sein können.

Wie anhand von Figur 4 deutlich wird, weist der Boden 16 innenseitig des Unterteils 2 eine Vertiefung 14 auf, die der formschlüssigen Aufnahme eines leistungselektronischen Bauelements, insbesondere eines den Elektromotor bestromenden Frequenzumrichters dient. Ein solches wärmeerzeugende Bauteil liegt entsprechend den Boden 16 kontaktierend insbesondere mittels einer Wärmeleitpaste in der Vertiefung 14 ein. Rückseitig besitzt der Boden 16 im gesamten Bereich der Vertiefung 14 einen axialen Vorsprung 17, der, wie in Figur 3 ersichtlich, seitlich neben dem Anlagebereich 10, und wie in Figur 1 ersichtlich, seitlich neben dem Elektromotor liegt.

Die Kühlrippen 6 enden alle auf gleicher Höhe, wobei die auf dem Vorsprung 17 liegenden Kühlrippen respektive Teilabschnitte der Kühlrippen in ihrer Höhe um die Höhe des Vorsprungs 17 kürzer sind als die übrigen Kühlrippen respektive die übrigen Teilbereiche, die außerhalb des Vorsprungs 17 liegen. Die Kühlrippen 6 erstrecken sich über einem Drittel bis etwa zur Hälfte der axialen Länge des Motorgehäuses 4 parallel zur Motorachse 19.

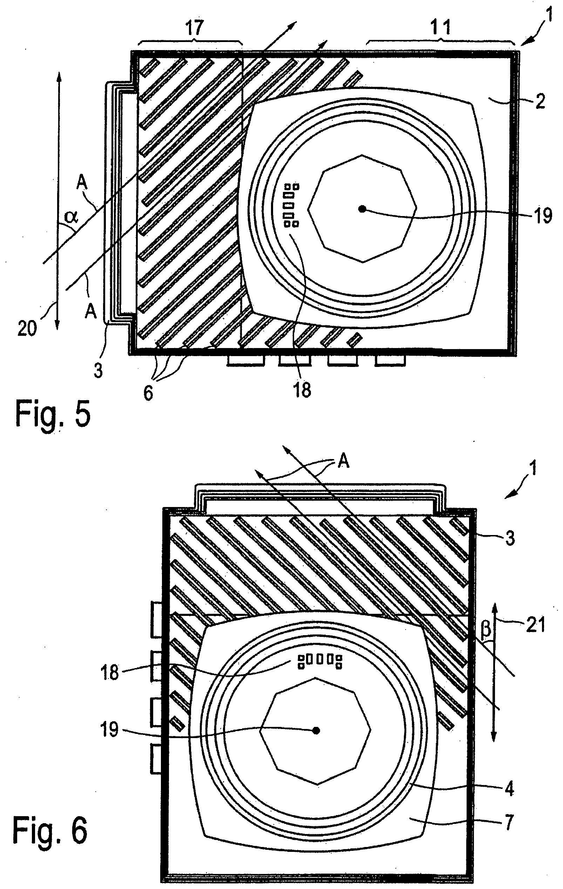

Wie nun anhand der Figuren 5 und 6 verdeutlicht wird, besteht ein Kernaspekt des erfindungsgemäßen Elektronikgehäuses darin, dass die Kühlrippen in einem Winkel A, B zu einer Erstreckungsrichtung 20, 21 der Rückseite 5 des Bodens 16 des Elektronikgehäuses 1 verlaufen. Da die geometrische Grundform des Unterteils 2 im Wesentlichen rechteckig ist, kann eine Quererstreckungsrichtung 20 wie in Figur 5 dargestellt und eine Längserstreckungsrichtung 21 wie in Figur 6 dargestellt definiert werden. Bezogen auf die Quererstreckungsrichtung liegen die Kühlrippen 6 in einem Winkel A bezogen auf die Längserstreckung in einem Winkel B. In der in den Figuren gezeigten Ausführungsvariante sind die beiden Winkel im Wesentlichen gleich, so dass die Rippen bezogen auf beide Erstreckungsrichtungen 45° schräg verlaufen.

Die Motorachse 19 respektive Pumpenachse 19 liegt in dem Figurenbeispiel horizontal, so dass die Stirnseite des Elektromotors und folglich auch die Rückseite des Bodens 16 in einer Vertikalebene liegen. Somit verlaufen die Kühlrippen 6 mit einer Steigung von 45° schräg nach oben. Figur 5 zeigt eine erste Einbauvariante der Zentrifugalpumpe, Figur 6 eine zweite Einbauvariante, die gegenüber der ersten Einbauvariante um 90° (mit Blick auf das Oberteil 3 gegen den Uhrzeigersinn) gedreht ist. Die Pfeile A in den Figuren 5 und 6, die die Strömungsrichtung einer Konvektionsströmung durch die Kühlkanäle 23 beschreiben, veranschaulichen, dass in jeder der beiden Einbaupositionen eine Konvektion ungehindert möglich ist. Dies wäre nicht möglich, wenn die Rippen parallel zu einer Erstreckungsrichtung verliefen. Durch einen Winkel A=B=45° ist ferner die Steigung der Kühlkanäle bei beiden Einbauvarianten identisch, so dass gleiche thermische Wärmeabgabeverhältnisse bestehen.

Steckkontakte 18, die im Unterteil 2 festgelegt sind und durch die Öffnung 12 hindurch zum Stator ragen, zeigen, dass die Montageposition des Elektronikgehäuses 1 relativ zum Motor bei beiden Einbauvarianten in den Figuren 5 und 6 gleich ist. Vielmehr wird lediglich der Anschluss der Zentrifugalpumpe an die vorhandenen Gegebenheiten des Rohrleitungssystems angepasst, so dass entweder die Zentrifugalpumpe von rechts nach links oder links nach rechts fördert oder von unten nach oben fördert.

Um eine Konvektion durch alle Kühlkanäle 23 zu ermöglichen, und nicht nur durch diejenigen, die nach oben hin offen sind, enden diejenigen Kühlrippen, deren Längserstreckung den Anlagebereich 10 berührt oder schneidet in einem Abstand vor diesem Anlagebereich 10, wie in Figur 3 deutlich wird. Im montierten Zustand des Elektronikgehäuses 1 enden somit die Kühlrippen vor dem Motorgehäuse 4, so dass ein Abstand zum Motorgehäuse entsteht, welche wiederum eine Konvektion in Umfangsrichtung des Motorgehäuses ermöglicht. Dies veranschaulicht der Pfeil B in Figur 3.

Bei der Zentrifugalpumpe kann es sich um eine Umwälzpumpe oder eine Kreiselpumpe, insbesondere eine Nassläuferpumpe handeln, die beispielsweise in einer Heizungsanlage, einer Kühlanlage, einer solarthermischen Anlage oder eine Druckerhöhungsanlage einer Trinkwasserinstallation eingebaut ist.

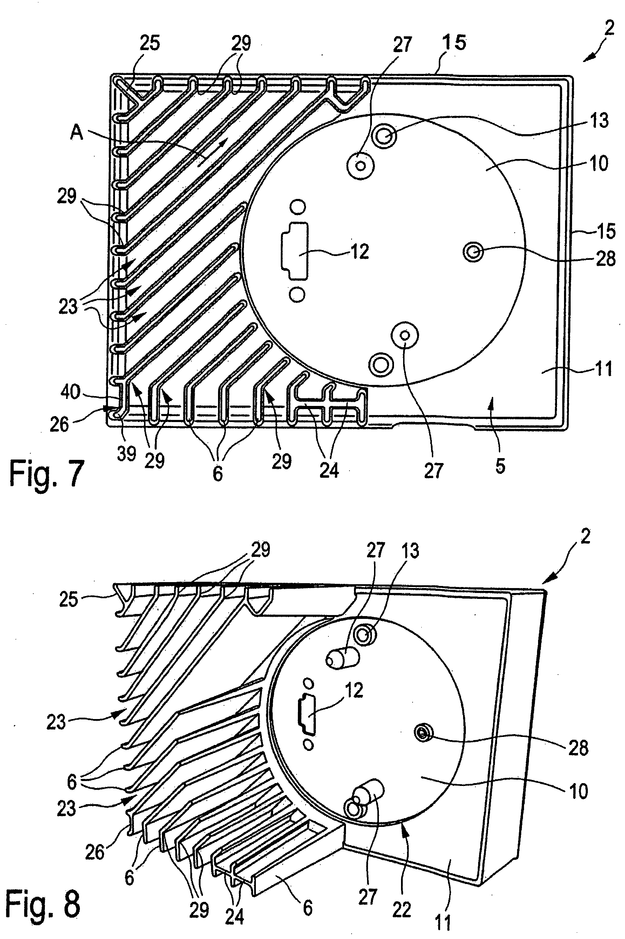

Figuren 7 bis 8 zeigen eine weitere Ausführungsvariante des Unterteils 2 eines erfindungsgemäßen Elektronikgehäuses 1, bei dem auf der dem Oberteil 3 abgewandten Rückseite 5 des Unterteils 2 Kühlrippen 6 einstückig mit dem Boden 16 ausgebildet sind, die abschnittsweise in einem Winkel von 45° zu einer Erstreckungsrichtung des Elektronikgehäuses 1, hier sowohl in Richtung der Längserstreckung 21 als auch in Richtung der Quererstreckung 20 seiner Rückseite 5 verlaufen.

Die weitere Ausführungsvariante unterscheidet sich von der Ausführungsvariante in den Figuren 1 bis 6 darin, dass die Kühlrippen 6 in Richtung ihres zu einer Seitenwand 15 hin auslaufenden Endes einen Knick 29 aufweisen, um rechtwinklig zur jeweiligen Seitenwand 15, d.h. parallel oder quer zu der einen Erstreckungsrichtung 20, 21 der Rückseite 5 auszulaufen. Der Knick 29 bewirkt somit einen Richtungswechsel. Soweit eine Rippe 6 zu zwei Seitenwänden 15 ausläuft besitzt sie zwei folgemäßig Knicke 29, um an beiden auslaufenden Enden rechtwinklig zur jeweiligen Seitenwand auszulaufen. Dies ist jedoch bei denjenigen Kühlrippen 6 nicht der Fall, deren Haupterstreckungsrichtung eine Sekante zum Anlagenbereich 10 bildet. Durch den Knick 29 oder die Knicke 29 besitzen die Kühlrippen 6 folglich einen ersten Abschnitt, der die Haupterstreckungsrichtung bildet und in dem 30°-60° bzw. hier in dem 45°-Winkel zu der einer Erstreckungsrichtung des Elektronikgehäuses 1 verläuft, sowie zumindest einen zweiten Abschnitt, der durch das an einer der Seitenwände 15 jeweils liegende Auslaufende gebildet ist.

Durch die Knicke 29 werden die Rippen in ihrer mechanischen Stabilität verstärkt. Darüber hinaus wird das optische Erscheinungsbild verbessert, da der Eintrittsbereich in die Kühlkanäle 23 nun nicht mehr winklig sondern in Blickrichtung auf jede der Seitenwände 15 des Elektronikgehäuses 1 liegt.

Darüber hinaus gibt es in der weiteren Ausführungsvariante Querrippen 24, die zwei benachbarte Kühlrippen 6 miteinander verbinden. Dies ist dort der Fall, wo die Kühlrippen 6 vergleichsweise kurz sind. Eine Querrippe 24 führt ebenfalls zu einer mechanischen Stabilisierung der verbundenen kurzen Kühlrippen 6. Zwar bilden die Querrippen eine Konvektions- bzw. Strömungssperre. Jedoch ist dies aufgrund der Verwendung bei nur relativ kurzen Kühlrippen 6 ohne merklichen Kühlleistungsverlust.

Wie anhand der Figuren 7 bis 9 ferner zu erkennen ist, ist in einer Ecke der Rückseite 5 des Bodens 16 eine Pseudorippe 26 angeordnet. Dies ist in jener Ecke der Fall, die in einer Flucht mit einem der Kühlkanäle 23 liegt. Da die diesen Kühlkanal 23 seitlich einfassenden Kühlrippen 6 zu verschiedenen Seitenwänden 15 hin abknicken, ergibt sich bei Fehlen der Pseudorippe 26 ein relativ großer Mündungsbereich für diesen Kühlkanal 23. Dies reduziert lokal die Strömungsgeschwindigkeit und führt zudem zu einem ungenutzten Bereich der Rückseite 5. Durch die Pseudorippe wird der Mündungsbereich verkleinert und ferner durch eine zur Kühlleistung beitragenden weiteren Kühlrippe 26 ausgenutzt.

Die Pseudorippe 26 geht in eine benachbarte Kühlrippe 6, d.h. eine die den besagten Kühlkanal 23 einfasst über. Sie weist zwei durch einen Knick 29 voneinander getrennte Abschnitte 39, 40 auf, wobei ein erster Abschnitt 39, der einen in der Ecke liegenden Anfangsabschnitt bildet, parallel zur Haupterstreckungsrichtung der anderen benachbarten Kühlrippe 6 und ein zweiter Abschnitt 40 parallel zu dem zu der entsprechenden Seitenwand 15 auslaufenden Ende dieser anderen benachbarten Kühlrippe 6 verläuft und die eine benachbarte Kühlrippe 6 übergeht.

Des Weiteren umfasst das Unterteil 2 gemäß der weiteren Ausführungsvariante in zumindest einer anderen Ecke der Rückseite 5 des Bodens 16 eine Stummelrippe 25. Dies ist in jener Ecke der Fall, an der eine Kühlrippe 6 vorbeiläuft, jenseits derer kein weiterer Kühlkanal liegt. Um den in dieser Ecke liegenden Bereich auszunutzen, ist dort die Stummelrippe 25 angeordnet. Diese ist gegenüber den anderen Kühlrippen vergleichsweise kurz. Sie erstreckt sich zudem quer zu den anderen Kühlrippen 6 und endet direkt in der Ecke, d.h. dort, wo zwei Seitenwände 15 aneinandergrenzen. Sie geht in die an der Ecke vorbeilaufenden Kühlrippe 6 einstückig über, so dass hier mechanische Stabilität gegeben ist.

Wie des Weiteren in den Figuren 7, 8 und 9 zu erkennen ist, weist der Boden 16 im Anlagenbereich 10 Dome 27 auf, die eine Führung beim Ansetzen des Elektronikgehäuses 1 an das Motorgehäuse 4 gewährleisten, so dass es nicht zu einem Verkanten und einer Beschädigung der Steckkontakte kommen kann.

Im Boden 16 ist eine Erdungspinaufnahme 28 in Gestalt einer Öffnung ausgebildet, durch die ein stiftförmiger Erdungsanschluss zur Erdung des Motorgehäuses hindurchgeführt werden kann. Dieser kontaktiert dann gleichzeitig das Unterteil 2 so dass auch die elektrisch leitfähigen Teile des Elektronikgehäuses geerdet werden.

Ein anderer Unterschied der weiteren Ausführungsvariante besteht darin, dass ihr Boden keine Vertiefung 14 und auch keinen Vorsprung 17 aufweist. Somit sind alle Rippen gleich lang in axialer Richtung parallel zur Motorachse 19. Eine andere Ausführungsvariante kann jedoch auch unterschiedlich lange Kühlrippen 6 aufweisen.

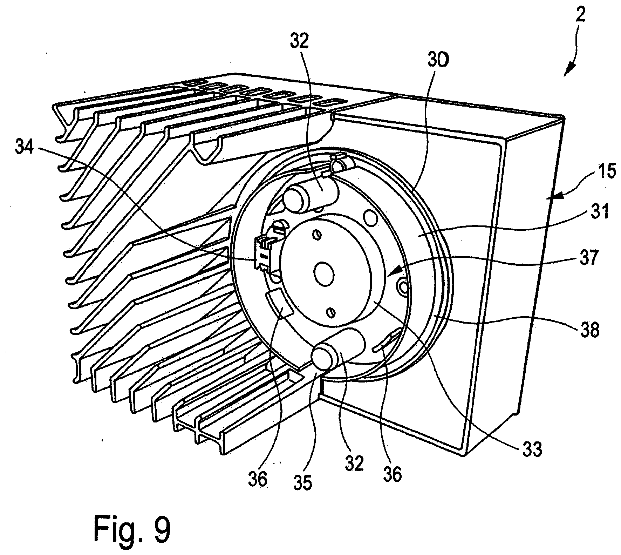

In Figur 9 ist die Rückseite 5 des Unterteils 2 des Elektronikgehäuses 1 mit einer Führungskappe 30 versehen, die im montierten Zustand des Elektronikgehäuses 1 auf der Stirnseite des Motorgehäuses 4 zwischen dem Elektronikgehäuse 1 und Motorgehäuse 4 liegt. Die Führungskappe 30 isoliert das Elektronikgehäuse vom Motorgehäuse 4 sowohl elektrisch als auch thermisch.

Die Führungskappe 30 weist eine in dem Rücksprung 22 am Boden 16 anliegende kreisrunde Grundplatte 38 auf, von der konzentrisch eine zylindrische Führungswand 31 absteht, die sich um das Zentrum der Platte 38 und die Motorachse 19 herum erstreckt. Diese kommt an ihrem der Platte 38 gegenüberliegenden axialen Ende in Anlage mit dem Motorgehäuse 4. Die Führungswand 31 ist zweigeteilt und besitzt oben und unten gegenüberliegend jeweils eine Unterbrechung, durch die der durch die Führungswand 31 gebildete Innenraum 37 nach außen hin offen ist. Dies dient einerseits der Belüftung. Zum anderen bildet die untere Unterbrechung eine an dem tiefsten Punkt der Führungswand 31 liegende Ablauföffnung 35 für sich eventuell innerhalb des Innenraums 37 bildendes Kondenswasser.

Mittig innerhalb des Innenraums 37 erhebt sich von der Platte 38 ein Zentralplateau 33, das als Abstandshalter dient. Es ist im Querschnitt kreisförmig und kommt mir seiner axialen Stirnseite in Anlage mit dem Motorgehäuse 4. Vier wandförmige Abstandshalter 36 sind symmetrisch und äquidistant um das Zentralplateau 33 angeordnet. Die wandförmigen Abstandshalter 36 gehen an einem axialen Ende ebenfalls in die Platte 38 über und bilden am gegenüberliegenden axialen Ende eine Anlage für das Motorgehäuse 4.

Ferner umfasst die Führungskappe 30 eine Steckkontaktaufnahme 34, in der die von der Steuerungselektronik im Elektronikgehäuse 1 kommenden Steckkontakte zur Kontaktierung mit korrespondierenden Statorkontakten einliegen.

Von der Platte 38 springen ebenfalls hohlzylindrische Domaufnahmen 32 hervor, die Führungszylinder bilden. Die Dome 27 des Unterteils 2 erstrecken sich auf der dem Motorgehäuse 4 abgewandten Seite der Führungskappe 30 in die Domaufnahmen 32 hinein. Die Domaufnahmen 32 sind an ihrem zum Motorgehäuse 4 gerichteten axialen Ende abgeschrägt, um ein leichtes Fügen des Elektronikgehäuses 1 mit automatischem Zentrieren zu erreichen. Die Domaufnahmen 32 greifen in entsprechende Öffnungen oder Vertiefungen an der Stirnseite des Motorgehäuses 4 ein. Insbesondere ermöglichen die Domaufnahmen 32 und die Führungswand 31 ein einfaches Ansetzen des Unterteils 2 des Elektronikgehäuses 1 an den Elektromotor ohne Verkanten und Beschädigung.

### Bezugszeichenliste

- 1: Elektronikgehäuse
- 2: Unterteil
- 3: Oberteil
- 4: Motorgehäuse
- 5: Unterteilrückseite
- 6: Kühlrippen
- 7: Motorflansch
- 8: Rippenbasis
- 9: freies Rippenende
- 10: Anlagebereich
- 11: rippenfreier Teilbereich der Rückseite
- 12: Öffnung
- 13: Bohrung
- 14: Vertiefung
- 15: Seitenwände
- 16: Boden
- 17: Vorsprung/ vorspringender Teilbereich des Bodens
- 18: elektrische Steckkontakte
- 19: Motorachse
- 20: Quererstreckungsrichtung des Unterteils
- 21: Längserstreckungsrichtung des Unterteils
- 22: Rücksprung
- 23: Kühlkanal
- 24: Querrippe
- 25: Stummelrippe
- 26: Pseudorippe
- 27: Dom
- 28: Erdungspinaufnahme
- 29: Knick
- 30: Führungskappe
- 31: zylindrische Führungswand
- 32: Führungszylinder
- 33: Zentralplateau, Abstandshalter
- 34: Steckkontaktaufnahme
- 35: Ablauföffnung
- 36: Wandauflagen, Abstandshalter
- 37: Innenraum
- 38: Platte
- 39: erster Abschnitt
- 40: zweiter Abschnitt

## Patentansprüche

1. Zentrifugalpumpe mit einem sie antreibenden Elektromotor und einem auf ein Motorgehäuse (4) des Elektromotors montierten Elektronikgehäuse (1) mit einem wannenförmigen Unterteil (2) zur Aufnahme zumindest eines wärmeerzeugenden Bauelements, insbesondere leistungselektronischer Bauelemente eines Frequenzumrichters, und einem das Unterteil (2) abdeckenden Oberteil (3), wobei das Unterteil (2) einen Boden (16) sowie sich davon in Richtung des Oberteils (3) erstreckende Seitenwände (15) aufweist, und zumindest der Boden (16) aus einem wärmeleitfähigen Material besteht, und auf der dem Oberteil (3) abgewandten Rückseite (5) des Unterteils (2) Kühlrippen (6) einstückig mit dem Boden (16) ausgebildet sind und sich parallel zur Motorachse erstrecken, **dadurch gekennzeichnet, dass** die Kühlrippen zumindest abschnittsweise in einem Winkel (α, β) zwischen 30° und 60° zu einer Erstreckungsrichtung (20, 21) der Rückseite (5) verlaufen, wobei die Kühlrippen (6) in Richtung ihres zu einer Seitenwand (15) hin auslaufenden Endes zumindest einen Knick (29) aufweisen, um rechtwinklig zur jeweiligen Seitenwand (15) auszulaufen.

2. Zentrifugalpumpe nach Anspruch 1, **dadurch gekennzeichnet, dass** der Winkel im Wesentlichen 45° beträgt.

3. Zentrifugalpumpe nach Anspruch 1 oder 2, **dadurch gekennzeichnet, dass** die Rückseite (5) des Bodens (16) einen kühlrippenfreien Anlagebereich (10) zum Ansetzen an das Motorgehäuse (4) aufweist, mit dem das Elektronikgehäuse (1) an eine axiale Stirnseite des Motorgehäuses (4) montiert ist, wobei die Kühlrippen (6) in radialer Richtung seitlich neben dem Motorgehäuse (4) liegen.

4. Zentrifugalpumpe nach Anspruch 3, **dadurch gekennzeichnet, dass** die Kühlrippen (6) in einem Abstand vor dem Anlagebereich (10) enden.

5. Zentrifugalpumpe nach einem der vorherigen Ansprüche, **dadurch gekennzeichnet, dass** ein Teilbereich (11) der Rückseite (5) des Bodens (16) frei von Kühlrippen (6) ist.

6. Zentrifugalpumpe nach einem der vorherigen Ansprüche, **dadurch gekennzeichnet, dass** der Boden (16) innenseitig des Unterteils (2) eine Vertiefung (14) zur bodenkontaktierenden Aufnahme des oder zumindest eines der Wärme abgebenden elektronischen Bauelements/ Bauelemente aufweist, wobei rückseitig dieser Vertiefung (14) Kühlrippen (6) vorhanden sind.

7. Zentrifugalpumpe nach Anspruch 6, **dadurch gekennzeichnet, dass** der Boden (16) außenseitig im gesamten Bereich der Vertiefung (14) einen Vorsprung (17) aufweist.

8. Zentrifugalpumpe nach Anspruch 7, **dadurch gekennzeichnet, dass** der Vorsprung (17) seitlich neben dem Anlagebereich (10) liegt.

9. Zentrifugalpumpe nach einem der vorherigen Ansprüche, **dadurch gekennzeichnet, dass** die Dicke der Kühlrippen (6) zu ihrem freien Ende (9) hin jeweils abnimmt.

10. Zentrifugalpumpe nach einem der vorherigen Ansprüche, **dadurch gekennzeichnet, dass** der Abstand zweier benachbarter Kühlrippen (6) dem 1,0 bis 5,0-fachen der Dicke der Kühlrippen (6) an ihrer bodennahen Basis (8) beträgt.

11. Zentrifugalpumpe nach einem der vorherigen Ansprüche, **dadurch gekennzeichnet, dass** in zumindest einer Ecke der Rückseite (5) des Bodens (16) eine Pseudorippe (26) angeordnet ist, die in eine benachbarte Kühlrippe (6) übergeht und zwei durch einen Knick voneinander getrennte Abschnitte (39, 40) aufweist, wobei der erste Abschnitt (39) parallel zur Haupterstreckungsrichtung der anderen benachbarten Kühlrippe (6) und der zweite Abschnitt (40) parallel zu dem zu einer Seitenwand (15) auslaufenden Ende dieser anderen benachbarten Kühlrippe (6) verläuft.

12. Zentrifugalpumpe nach einem der vorherigen Ansprüche, **dadurch gekennzeichnet, dass** in zumindest einer Ecke der Rückseite (5) des Bodens (16) eine Stummelrippe (25) angeordnet ist, die sich quer zu den übrigen Kühlrippen (6) erstreckt.

13. Zentrifugalpumpe nach einem der vorherigen Ansprüche, **dadurch gekennzeichnet, dass** die Kühlrippen (6) das Motorgehäuse (4) in einem Abstand umgeben.

14. Zentrifugalpumpe nach einem der vorherigen Ansprüche, **dadurch gekennzeichnet, dass** sich die Kühlrippen (6) über zumindest ein Viertel der axialen Länge des Motorgehäuses (4) erstrecken.

15. Zentrifugalpumpe nach einem der vorherigen Ansprüche, **dadurch gekennzeichnet, dass** das Unterteil (2) des Elektronikgehäuses (1) einen im Wesentlichen rechteckförmigen Querschnitt aufweist und das Motorgehäuse (4) an einer Seite weiter überragt als an der gegenüberliegenden anderen Seite und dass der Boden (16) zumindest an dieser einen Seite Kühlrippen (6) aufweist.

## Claims

1. Centrifugal pump with an electric motor that drives it and an electronics housing (1), mounted on a motor housing (4) of the electric motor, having a trough-shaped lower section (2) to hold at least one heat-generating component, in particular power electronics components of a frequency converter, and an upper section (3) covering the lower section (2), in which the lower section (2) has a floor (16) and side walls (15) extending from there in the direction of the upper section (3), and at least the floor (16) is made of a thermally conductive material, with cooling fins (6) on the back (5) of the lower section (2) facing away from the upper section (3) formed in one piece with the floor (16) and extending parallel to the motor axis, **characterised by** the cooling fins, at least in part, running at an angle (α, β) between 30° and 60° to an extension direction (20, 21) of the back (5), in which the cooling fins (6) have at least one bend (29) in the direction of their end terminating at a side wall (15) in order to terminate perpendicular to the respective side wall (15).

2. Centrifugal pump according to claim 1, **characterised by** the angle essentially being 45°.

3. Centrifugal pump according to claim 1 or 2, **characterised by** the back (5) of the floor (16) having a mounting face (10) free of cooling fins for locating the motor housing (4), with which the electronics housing (1) is mounted on an axial face side of the motor housing (4), in which the cooling fins (6) lie in a radial direction laterally next to the motor housing (4).

4. Centrifugal pump according to claim 3, **characterised by** the cooling fins (6) ending at a distance from the mounting face (10).

5. Centrifugal pump according to one of the preceding claims, **characterised by** a partial area (11) on the back (5) of the floor (16) being free of cooling fins (6).

6. Centrifugal pump according to one of the preceding claims, **characterised by** the floor (16) on the inner side of the lower section (2) having a recess (14) to hold, in contact with the floor, the or at least one electronic component(s) emitting heat, with cooling fins (6) on the back of this recess (14).

7. Centrifugal pump according to claim 6, **characterised by** the floor (16) having a protrusion (17) on the outer side in the entire area of the recess (14).

8. Centrifugal pump according to claim 7, **characterised by** the protrusion (17) lying laterally next to the mounting face (10).

9. Centrifugal pump according to one of the preceding claims, **characterised by** the thickness of the cooling fins (6) decreasing respectively towards their free end (9).

10. Centrifugal pump according to one of the preceding claims, **characterised by** the distance between two adjacent cooling fins (6) being 1.0 to 5.0 times the thickness of the cooling fins (6) at their base near the floor (8).

11. Centrifugal pump according to one of the preceding claims, **characterised by** a pseudo-fin (26) being arranged in at least one corner of the back (5) of the floor (16), transitioning into an adjacent cooling fin (6) and having two sections separated from each other by a bend (39, 40), in which the first section (39) runs parallel to the main extension direction of the other adjacent cooling fin (6) and the second section (40) runs parallel to the end of this other adjacent cooling fin (6) terminating at a side wall (15).

12. Centrifugal pump according to one of the preceding claims, **characterised by** a stub fin (25) being arranged in at least one corner of the back (5) of the floor (16), extending crosswise to the remaining cooling fins (6).

13. Centrifugal pump according to one of the preceding claims, **characterised by** the cooling fins (6) surrounding the motor housing (4) at a distance.

14. Centrifugal pump according to one of the preceding claims, **characterised by** the cooling fins (6) extending over at least one quarter of the axial length of the motor housing (4).

15. Centrifugal pump according to one of the preceding claims, **characterised by** the lower section (2) of the electronics housing (1) having an essentially rectangular cross-section and the motor housing (4) projecting further on one side than on the opposite side, and the floor (16) having cooling fins (6) at least on this one side.

## Revendications

1. Pompe centrifuge entraînée par un moteur électrique avec, monté sur le carter du moteur électrique (4), un boîtier électronique (1) dont la partie inférieure (2) en forme de bac est destinée à recevoir au moins un élément de construction générateur de chaleur, en particulier les éléments de construction d'électronique de puissance d'un convertisseur de fréquences, et dont la partie supérieure (3) recouvre la partie inférieure (2), sachant que la partie inférieure (2) présente un fond (16) et des parois latérales (15) s'étendant en direction de de la partie supérieure (3), qu'au moins le fond (16) est composé d'un matériau conducteur de chaleur et que le dos (5) de la partie inférieure (2) orienté dans le sens opposé à la partie supérieure (3) présente des ailettes de refroidissement (6) faisant un avec le fond (16) et s'étendant parallèlement à l'axe du moteur, **caractérisée en ce que** les ailettes de refroidissement, tout au moins en partie sont orientées avec un angle (α, β) entre 30° et 60° par rapport à une direction d'extension (20, 21) du dos (5), sachant que les ailettes de refroidissement (6) présentent au moins un coude (29) en direction de leur extrémité orientée vers une paroi latérale (15), pour se terminer à angle droit de ladite paroi latérale (15).

2. Pompe centrifuge selon la revendication 1, **caractérisée en ce que** l'angle est sensiblement de 45°.

3. Pompe centrifuge selon les revendications 1 ou 2, **caractérisée en ce que** le dos (5) du fond (16) présente une surface de pose (10) sans ailettes à poser contre le carter du moteur (4) avec laquelle le boîtier électronique (1) est monté sur la face axiale du carter du moteur (4), sachant que les ailettes de refroidissement (6) sont alignées en direction radiale latéralement à côté du carter du moteur (4).

4. Pompe centrifuge selon la revendication 3, **caractérisée en ce que** les ailettes de refroidissement (6) se terminent à une distance de la surface de pose (10).

5. Pompe centrifuge selon l'une des revendications précédentes, **caractérisée en ce qu'**une partie (11) du dos (5) du fond (16) ne présente pas d'ailettes de refroidissement (6).

6. Pompe centrifuge selon l'une des revendications précédentes, **caractérisée en ce que** le fond (16) à l'intérieur de la partie inférieure (2) présente un renfoncement (14) pour la réception en contact avec le fond du ou d'un des éléments de construction électroniques générateurs de chaleur, sachant que des ailettes de refroidissement (6) sont montées au dos de ce renfoncement (14).

7. Pompe centrifuge selon la revendication 6, **caractérisée en ce que** le fond (16) côté extérieur présente une saillie (17) sur toute la surface du renfoncement (14).

8. Pompe centrifuge selon la revendication 7, **caractérisée en ce que** la saillie (17) est placée latéralement à côté de la surface de pose (10).

9. Pompe centrifuge selon l'une des revendications précédentes, **caractérisée en ce que** l'épaisseur des ailettes de refroidissement (6) diminue en direction de leur extrémité libre (9).

10. Pompe centrifuge selon l'une des revendications précédentes, **caractérisée en ce que** la distance entre deux ailettes de refroidissement voisines (6) représente de 1 à 5 fois l'épaisseur des ailettes de refroidissement (6) au niveau de leur base (8) sur le fond.

11. Pompe centrifuge selon l'une des revendications précédentes, **caractérisée en ce que**, dans au moins un coin du dos (5) du fond (16), est disposée une pseudo-ailette (26) dont l'extrémité est tournée vers l'ailette (6) voisine et en cela présente deux sections (39, 40) séparées par un coude, la première section (39) étant parallèle à la direction d'extension principale de l'ailette (6) voisine et la seconde section (40) étant parallèle à l'extrémité dirigée vers la paroi latérale (15) de cette ailette (6) voisine.

12. Pompe centrifuge selon l'une des revendications précédentes, **caractérisée en ce que**, dans au moins un coin du dos (5) du fond (16), est disposée une ailette de transition (25) positionnée perpendiculairement aux autres ailettes de refroidissement (6).

13. Pompe centrifuge selon l'une des revendications précédentes, **caractérisée en ce que** les ailettes de refroidissement (6) contournent le carter du moteur (4) à une certaine distance.

14. Pompe centrifuge selon l'une des revendications précédentes, **caractérisée en ce que** les ailettes de refroidissement (6) s'étendent sur au moins un quart de la longueur axiale du carter du moteur (4).

15. Pompe centrifuge selon l'une des revendications précédentes, **caractérisée en ce que** la partie inférieure (2) du boîtier électronique (1) présente une section transversale sensiblement rectangulaire et que le carter du moteur (4) dépasse d'un côté plus que du côté opposé et qu'au moins à cet endroit, le fond (16) présente des ailettes de refroidissement (6).
